(19) Europäisches Patentamt
European Patent Office
Office européen des brevets

(11) **EP 3 879 288 B1**

(12) **FASCICULE DE BREVET EUROPEEN**

(45) Date de publication et mention de la délivrance du brevet:
**04.05.2022 Bulletin 2022/18**

(21) Numéro de dépôt: **21157059.3**

(22) Date de dépôt: **15.02.2021**

(51) Classification Internationale des Brevets (IPC):
**G01R 31/327** (2006.01) **G01R 31/333** (2006.01)

(52) Classification Coopérative des Brevets (CPC):
**G01R 31/3274; G01R 31/3336**

(54) **PROCÉDÉ DE TEST DE COUPURE DE COURANT CAPACITIF D'UN DISJONCTEUR**

VERFAHREN ZUM TESTEN DES ABSCHALTENS DES KAPAZITIVEN STROMS EINES LEISTUNGSSCHALTERS

METHOD FOR TESTING CAPACITIVE CURRENT CUT-OFF OF A CIRCUIT BREAKER

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **13.03.2020 FR 2002516**

(43) Date de publication de la demande:
**15.09.2021 Bulletin 2021/37**

(73) Titulaire: **Schneider Electric Industries SAS**
**92500 Rueil-Malmaison (FR)**

(72) Inventeurs:
• **ALBERTO, Diego**
**38700 Corenc (FR)**
• **GAUTHIER, Jean-Pierre**
**38210 Vourey (FR)**
• **PAPILLON, Anthony**
**38000 Grenoble (FR)**
• **GODECHOT, Xavier**
**34830 JACOU (FR)**

(74) Mandataire: **Schneider Electric**
**Service Propriété Industrielle**
**35, rue Joseph Monier**
**92500 Rueil-Malmaison (FR)**

(56) Documents cités:
**DE-B- 1 181 322**

• **SILI YAO ET AL: "Discussion on the problem about capacitive current switching of EHV and UHV AC circuit breaker", 2017 4TH INTERNATIONAL CONFERENCE ON ELECTRIC POWER EQUIPMENT - SWITCHING TECHNOLOGY (ICEPE-ST), IEEE, 22 octobre 2017 (2017-10-22), pages 771-777, XP033267755, DOI: 10.1109/ICEPE-ST.2017.8188955**
• **GAETAN DAIGNEAULT ET AL: "Comparing Direct and Synthetic Tests for Interruption of Line-Charging Capacitive Current", IEEE TRANSACTIONS ON POWER DELIVERY, IEEE SERVICE CENTER, NEW YORK, NY, US, vol. 16, no. 3, 1 juillet 2001 (2001-07-01), XP011050060, ISSN: 0885-8977**
• **SHUI-CHEONG KAM ET AL: "A circuit-breaker restrike diagnostic algorithm using ATP and wavelet transforms", UNIVERSITIES POWER ENGINEERING CONFERENCE (AUPEC), 2011 21ST AUSTRALASIAN, IEEE, 25 septembre 2011 (2011-09-25), pages 1-6, XP032073926, ISBN: 978-1-4577-1793-2**

**Description**

**Domaine technique**

La présente invention concerne les disjoncteurs et plus particulièrement le domaine des tests d'endurance de coupure de courant capacitif d'un disjoncteur.

**État de l'art antérieur**

Si on considère un équipement électrique, par exemple une ligne électrique ou une batterie de condensateurs, le phénomène de courant capacitif apparaît à la mise sous tension de l'équipement électrique. Il s'agit d'un courant alternatif permanent qui traverse la capacité de l'équipement électrique entre phase et terre.

Il est connu d'assurer une protection de l'équipement électrique en mettant en œuvre des disjoncteurs. Les disjoncteurs sont testés par des essais d'établissement et de coupure de courant qui sont définis notamment par la norme internationale CEI (Commission Electrotechnique Internationale) 62271-100 ou la norme IEEE (Institut des Ingénieurs Electriciens et Electroniciens) C37.100.2. Ces essais ont pour but de démontrer les performances d'un disjoncteur à moyenne et/ou haute tension à courant alternatif. Parmi ces essais, on s'intéresse à ceux concernant l'établissement et la coupure de courants capacitifs. Les cas les plus typiques d'application sont les mises sous tension et hors tension de lignes aériennes à vide (circuit ouvert à son autre extrémité), de câbles à vide et de batteries de condensateurs.

Pendant la durée de vie d'un disjoncteur, le nombre d'opérations de coupure de courant capacitif qu'il doit réaliser peut être par exemple de quelques milliers dans le cas de manœuvres quotidiennes. Il est donc souhaitable d'avoir une station de test qui permette d'effectuer un grand nombre, typiquement 10000, d'opérations de coupure capacitive. Dans chacun des résultats de test, on recherche des phénomènes transitoires qui sont des chutes de tension très rapides. Les phénomènes recherchés sont rares et relativement difficiles à détecter. Il faut donc repérer ces chutes de tension très rapides.

Une campagne de test implique donc un grand nombre de tests et un traitement des résultats de mesure pour détecter des phénomènes transitoires qui sont par nature aléatoires.

Les documents suivants divulguent des examples de procédés et de circuits de test de coupure de courant capacitif d'un disjoncteur:

- SILI YAO ET AL: "Discussion on the problem about capacitive current switching of EHV and UHV AC circuit breaker",2017 4TH INTERNATIONAL CONFERENCE ON ELECTRIC POWER EQUIPMENT - SWITCHING TECHNOLOGY (ICEPE-ST), IEEE, 22 octobre 2017;
- GAETAN DAIGNEAULT ET AL: "Comparing Direct and Synthetic Tests for Interruption of Line-Charging Capacitive Current",IEEE TRANSACTIONS ON POWER DELIVERY, IEEE SERVICE CENTER, NEW YORK, NY, US, vol. 16, no. 3, 1 juillet 2001 ;
- DE 11 81 322 B;
- SHUI-CHEONG KAM ET AL: "A circuit-breaker restrike diagnostic algorithm using ATP and wavelet transforms",UNIVERSITIES POWER ENGINEERING CONFERENCE (AUPEC), 2011 21ST AUSTRALASIAN, IEEE, 25 septembre 2011 (2011-09-25).

Exposé de l'invention

L'invention vise à résoudre les problèmes de la technique antérieure en fournissant un procédé de test de coupure de courant capacitif d'un disjoncteur selon la revendication 1.

Grâce à l'invention, il est possible de tester la capacité de coupure de courant capacitif d'un disjoncteur, de manière à pouvoir le qualifier, faire une maintenance prédictive ou encore mesurer les effets du vieillissement sur ses performances de coupure de courant capacitif. L'invention permet plus particulièrement de détecter les chutes de tension très rapides correspondant à des réamorçages. Il est ainsi possible d'évaluer les défauts de réamorçage du disjoncteur.

Selon une caractéristique préférée, la tension est mesurée avec une fréquence d'échantillonnage supérieure à 10 MHz. Ainsi les phénomènes recherchés qui sont très rapides peuvent être détectés.

Selon une caractéristique préférée, l'étape de calcul du gradient de la tension mesurée comporte un filtrage passe-haut de la tension mesurée.

Selon une caractéristique préférée, le disjoncteur comportant plusieurs phases, le procédé étant effectué pour chaque phase, le procédé comporte les étapes supplémentaires de :

- Interpolation des valeurs de mesure de tension aux bornes du disjoncteur après l'instant de chute de tension, pour obtenir une courbe de tension, pour chaque phase,
- Calcul d'un temps de recharge de la courbe de tension obtenue, pour chaque phase,
- Comparaison du temps de recharge de la courbe de tension obtenue avec un temps de recharge prédéterminé, pour chaque phase,
- Identification d'une phase pour laquelle il y a correspondance entre le temps de recharge calculé et le temps de recharge prédéterminé.

Selon une caractéristique préférée alternative, le disjoncteur comportant plusieurs phases, le procédé étant effectué pour chaque phase, le procédé comporte les étapes supplémentaires de :

- Comparaison de la valeur absolue de l'amplitude de gradient pour chaque point déterminé pour chaque phase, avec un second seuil prédéterminé,
- Identification d'une phase pour laquelle la valeur absolue de l'amplitude de gradient au point déterminé est supérieure au second seuil prédéterminé.

Ainsi, pour un disjoncteur multiphasé, il est possible de discriminer la phase pour laquelle se produit une chute de tension très rapide correspondant à un réamorçage et la ou les phases ne subissant qu'un effet diaphonique.

L'invention concerne aussi une station de test de coupure de courant capacitif d'un disjoncteur selon la revendication 6.

Selon une caractéristique préférée, la station de test de coupure de courant capacitif d'un disjoncteur comporte :

- Un module électrique pour créer le courant d'appel,
- Un module électrique pour créer le courant capacitif,
- Un module électrique pour créer la tension de rétablissement après une coupure capacitive,
- Un module de synchronisation pour synchroniser les modules électriques précédents. Selon une caractéristique préférée, le module électrique pour créer la tension de rétablissement après une coupure capacitive comporte une source de basse tension à amplitude et fréquence réglable, un transformateur-élévateur et un circuit de redressement.

Dans un mode particulier de réalisation, la station de test de coupure de courant capacitif d'un disjoncteur comprend un ordinateur. Par ordinateur, on comprend un système de traitement d'information programmable, par exemple un module de traitement, permettant notamment réaliser le procédé selon l'invention.

Les étapes du procédé selon l'invention, notamment les étapes E3 à E8, sont mises en œuvre par des instructions de programme d'ordinateur.

En conséquence, l'invention vise aussi un programme d'ordinateur sur un support d'informations, ce programme étant susceptible d'être mis en œuvre dans un ordinateur, ce programme comportant des instructions adaptées à la mise en œuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en œuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

**Brève description des dessins**

D'autres caractéristiques et avantages apparaîtront à la lecture de la description suivante d'un mode de réalisation préféré donné à titre d'exemple non limitatif, décrit en référence aux figures dans lesquelles :

[Fig. 1] illustre un procédé de test de coupure de courant capacitif d'un disjoncteur, selon un mode de réalisation de l'invention,

[Fig. 2] illustre un exemple de tension mesurée aux bornes d'une phase d'un disjoncteur lorsque celui-ci coupe un courant capacitif,

[Fig. 3] illustre le gradient de la tension représentée à la figure 2,

[Fig. 4] illustre un autre exemple de tension mesurée aux bornes d'une phase d'un disjoncteur lorsque celui-ci coupe un courant capacitif,

[Fig. 5] illustre la recharge de la tension représentée à la figure 2,

[Fig. 6] illustre la station de test de coupure de courant capacitif d'un disjoncteur, selon un mode de réalisation de l'invention,

[Fig. 7] illustre un exemple de courant d'appel mis en œuvre dans le cadre de l'invention,

[Fig. 8] illustre un exemple de courant capacitif et de tension de rétablissement mis en œuvre dans le cadre de l'invention,

[Fig. 9] illustre un module électrique pour créer une tension de rétablissement, dans la station de test de coupure de courant capacitif d'un disjoncteur de la figure 6.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**Exposé détaillé de modes de réalisation particuliers**

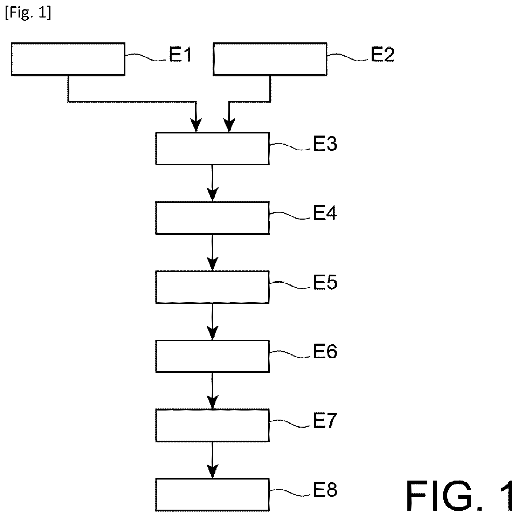

Selon un mode de réalisation préféré, représenté à la **figure** 1, le procédé de test de coupure de courant capacitif d'un disjoncteur comporte des étapes E1 à E8 qui sont appliquées à un disjoncteur pour évaluer sa capacité de coupure de courant capacitif.

Le procédé est mis en œuvre dans une station de test prévue pour fournir un courant d'appel ajustable, par exemple entre 2 et 20 kA et des tensions par exemple entre 10 et 52 kV en moyenne tension et des valeurs de tension supérieures en haute tension. La station de test de coupure de courant capacitif d'un disjoncteur comporte deux parties principales :

* Une station d'essais capacitive, et
* une chaine d'acquisition et de traitement de données pour effectuer des mesures avec une haute précision.

La station de test de coupure de courant capacitif d'un disjoncteur est décrite plus en détail dans la suite.

Le disjoncteur étudié est plus particulièrement un disjoncteur à vide. Il peut aussi être un disjoncteur au SF6 (Hexafluorure de soufre).

Les phénomènes mesurés sont des chutes de tension très rapides. Il est donc nécessaire de les mesurer avec une fréquence d'échantillonnage élevée, par exemple d'au moins 10 MHz. Ces chutes de tension très rapides sont mesurées, mémorisées et comptabilisées.

Il est à noter que pour un disjoncteur multiphasé, les mesures sont effectuées phase par phase pour détecter les chutes de tension très rapides sur chaque phase. Comme détaillé dans la suite, les résultats obtenus sur les différentes phases sont comparés pour déterminer quelle phase a subi un phénomène de chutes de tension très rapides correspondant à un réamorçage, de manière à faire une discrimination entre les phénomènes de réamorçage et les effets diaphoniques.

On suppose qu'un disjoncteur a été disposé en conditions de test dans la station de test. Le disjoncteur est placé dans un circuit électrique de manière à être en situation de pouvoir couper un courant capacitif.

L'étape E1 est l'établissement du courant d'appel.

L'étape E2 est l'établissement du courant capacitif suivi de la coupure de ce courant capacitif, puis l'apparition de la tension de rétablissement, avec la mesure de tension aux bornes du disjoncteur pendant la coupure de courant capacitif et surtout pendant l'apparition de la tension de rétablissement.

Pour un disjoncteur multiphasé, les mesures sont effectuées phase par phase. Les résultats de mesure sont mémorisés.

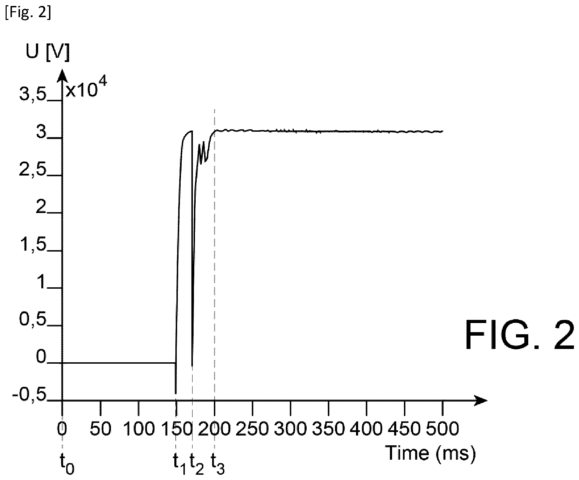

La **figure 2** représente un exemple de tension mesurée aux bornes d'une phase d'un disjoncteur lorsque celui-ci coupe un courant capacitif.

Dans l'exemple représenté, la tension est nulle entre les instants to = 0 et $t_1$ = 150 ms. A partir de l'instant $t_1$ = 150 ms correspondant à l'ouverture du disjoncteur, la tension croit rapidement jusqu'à une valeur d'environ 30 kV. A l'instant $t_2$ valant environ 170 ms, la tension présente une chute très rapide pendant laquelle sa valeur devient sensiblement nulle. Entre l'instant $t_2$ et l'instant $t_3$ valant environ 200 ms, la valeur de la tension remonte vers 30 kV avec quelques oscillations. Enfin, à partir de l'instant $t_3$, la valeur de la tension demeure sensiblement égale à 30 kV.

Le phénomène étudié est la chute de tension très rapide apparaissant vers 170 ms. Il s'agit d'un phénomène transitoire, il est donc nécessaire d'effectuer les mesures avec une fréquence d'échantillonnage élevée, typiquement supérieure à 10 MHz, ou supérieure à 20 MHz, ou encore supérieure à 30 MHz.

L'étape suivante E3 est un filtrage passe-haut de la tension mesurée pour mettre en évidence les phénomènes rapides et éliminer les variations lentes du signal. Le filtrage passe-haut est effectué pour chaque phase en cas d'acquisitions de tension pour plusieurs phases.

Le filtrage passe-haut de la tension mesurée est par exemple effectué par calcul du gradient, ou encore dérivée, de la tension mesurée.

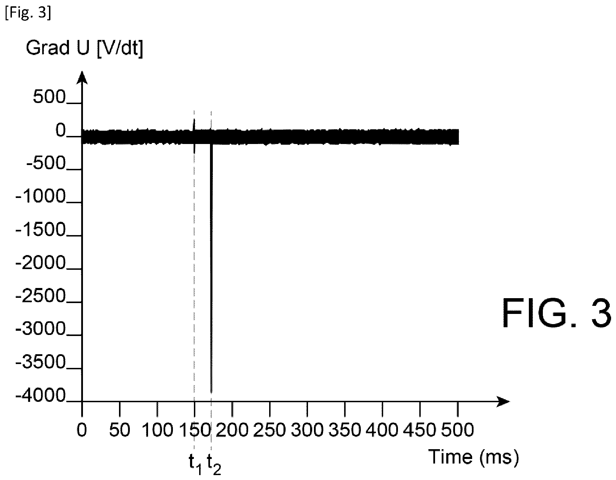

La **figure 3** représente le gradient de la tension représentée à la figure 2. Le gradient demeure dans une plage de valeurs centrée sur zéro, sauf aux instants $t_1$ et $t_2$.

On voit sur cette figure que le gradient de la tension présente un premier pic à l'instant $t_1$ correspondant à l'ouverture du disjoncteur.

On constate également que le gradient de la tension présente un second pic à l'instant $t_2$. L'étape suivante E4 est la détermination s'il existe au moins un point de gradient dont l'amplitude présente une valeur absolue supérieure à un premier seuil prédéterminé. Ce seuil dépend de préférence de la puissance du bruit.

Dans l'exemple de la figure 3, le second pic est identifié comme répondant positivement au test de l'étape E4.

Dans ce cas, c'est-à-dire lorsqu'un tel point est déterminé, l'étape E4 est suivie de l'étape E5 qui est l'identification et la mémorisation de l'instant $t_2$ d'apparition du point déterminé et de l'amplitude de variation de la tension à cet instant, en tant que chute de tension très rapide.

Le phénomène identifié et mémorisé est un réamorçage du disjoncteur.

Dans le cas où le disjoncteur comporte plusieurs phases, les étapes précédentes E2 à E5 sont parcourues pour chaque phase.

Lors d'une campagne de test d'endurance capacitive d'un disjoncteur comportant plusieurs phases, il peut arriver que les signaux de tension présentent des variations brusques synchrones sur plusieurs phases dues à des effets diaphoniques.

Par « effet diaphonique » ou encore « effet miroir », on entend qu'une chute de tension très rapide sur une phase entraine également une chute de tension très rapide sur les autres phases due au couplage capacitif entre phases, bien qu'il n'y ait pas eu de réamorçage sur les autres phases.

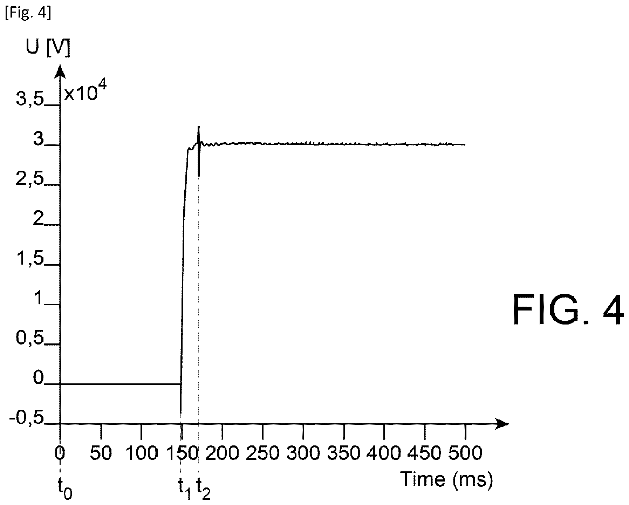

Pour illustrer ce phénomène, la **figure 4** représente la tension mesurée aux bornes d'une autre phase du disjoncteur que celle représentée à la figure 2, cette autre phase subissant des effets diaphoniques, lorsque le disjoncteur coupe un courant capacitif.

Dans l'exemple représenté, la tension est nulle entre les instants t0 = 0 et t1 = 150 ms. A partir de l'instant t1 = 150 ms correspondant à l'ouverture du disjoncteur, la tension croit rapidement jusqu'à une valeur d'environ 30 kV.

A l'instant t2 valant environ 170 ms, la tension présente une chute très rapide, d'amplitude plus faible que celle, au même instant, de la tension représentée à la figure 2. A partir de l'instant t2, la valeur de la tension se stabilise vers 30 kV avec quelques oscillations.

Il est à noter que les chutes de tension provoquées par des effets diaphoniques ne dégradent pas le disjoncteur et doivent donc être exclues de l'analyse.

Dans de tels cas, pour pouvoir distinguer les vrais phénomènes de réamorçage et des effets diaphoniques dus au couplage capacitif entre phases, une classification et une analyse plus détaillée sont nécessaires.

Selon une première variante de réalisation, le procédé comporte les étapes supplémentaires E6 à E8 suivantes.

L'étape E6 est l'interpolation des valeurs de tension juste après la chute très rapide de tension, c'est-à-dire pendant la remontée de tension, pour obtenir une courbe de tension. Etant donné que cette remontée de tension est exponentielle (loi de recharge de condensateur), on estime les temps de recharge sur chaque phase du disjoncteur, et on les compare avec un temps de recharge prédéterminé $\tau$ qui est fonction de la configuration de la station de test.

Le temps de recharge prédéterminé $\tau$ correspond au produit d'une résistance globale équivalente $R_{eq}$ et d'une capacité équivalente $C_{eq}$ de la station de test utilisée pour tester le disjoncteur.

$$\tau = R_{eq} * C_{eq}$$

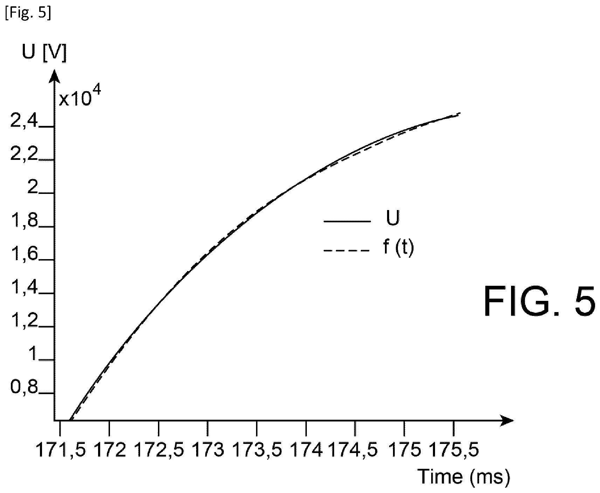

La **figure 5** représente la recharge de la tension représentée à la figure 2, entre les instant 171,5 ms et 175,5 ms.

Le temps de recharge pour la phase ayant réellement subi un phénomène de chute de tension très rapide, par opposition à un effet diaphonique dû au couplage capacitif entre phases, est proche de celui de la station de test.

Ainsi, la courbe de recharge illustrée à la figure 5 peut être modélisée par une équation de type :

$$f(t) = -a.e^{-t/\tau 1} + c$$

où t représente le temps, a et c sont des constantes et $\tau 1$ est le temps de recharge. La courbe représentant la fonction f(t) est tracée en pointillés.

Pour la phase ayant réellement subi un phénomène de chute de tension très rapide, le temps de recharge $\tau 1$ est sensiblement égal au temps de recharge prédéterminé $\tau$.

Pour les phases ayant subi un effet diaphonique, le temps de recharge $\tau 1$ est sensiblement différent du temps de recharge prédéterminé $\tau$.

Un deuxième paramètre permettant de quantifier la qualité de l'interpolation est la qualité de l'ajustement - typiquement supérieur à 99%.

Il est à noter que lorsque la détection à l'étape E4 n'est effectuée que sur une phase, L'étape E6 d'interpolation est tout de même réalisée, que ce soit dans un cas monophasé, ou dans un cas multiphasé dans lequel on ne détecte une chute de tension très rapide que sur une phase. Cela permet de distinguer un vrai réamorçage d'un phénomène de bruit.

L'étape suivante E7 est l'identification de la phase pour laquelle il y a correspondance entre le temps de recharge du disjoncteur après une chute de tension rapide avec le temps de recharge prédéterminé, en fonction du résultat de l'étape E6.

L'étape suivante E8 est la mémorisation du résultat de l'étape E7.

Si le type de produit à tester est connu et quelques centaines de mesures de tension sont déjà acquises, il est possible de s'affranchir de l'étape d'interpolation. Ainsi, selon une seconde variante de réalisation, le procédé comporte alors les étapes supplémentaires E6 à E8 suivantes.

L'étape E6 est une comparaison de la valeur absolue de l'amplitude de gradient pour chaque point déterminé pour chaque phase, avec un second seuil prédéterminé.

Le second seuil de gradient est défini en analysant les mesures à disposition. Ce seuil permet de statuer sur la nature du phénomène détecté et, dans les cas de détection synchrones sur plusieurs phases, de faire une discrimination entre les véritables chutes très rapides de tension et les effets diaphoniques.

L'étape suivante E7 est l'identification d'une phase pour laquelle la valeur absolue de l'amplitude de gradient au point déterminé est supérieure au second seuil prédéterminé. Cette phase est celle qui a subi un véritable défaut de réamorçage. Les autres phases, pour lesquelles la valeur absolue de l'amplitude de gradient au point déterminé est inférieure au second seuil prédéterminé, ont subi des effets diaphoniques.

En d'autres termes, pour l'une des phases, la variation de tension est plus importante que pour les autres. Le gradient de tension pour cette phase a une amplitude plus importante que celui des autres phases.

L'étape suivante E8 est la mémorisation du résultat de l'étape E7.

Les étapes précédemment décrites sont répétées un grand nombre de fois au cours d'une campagne de test du disjoncteur.

Il est à noter que l'intervalle de temps entre deux défauts consécutifs détectés est pris en compte. En effet, chaque défaut de réamorçage détecté qui suit un défaut de réamorçage précédent avec un intervalle de temps inférieur à une durée sensiblement égale au temps de recharge de la station de test est considéré comme le même phénomène que le défaut précédent.

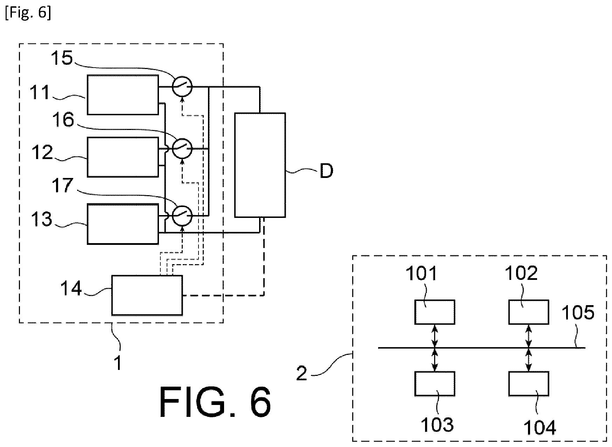

En référence à la **figure 6,** la station de test de coupure de courant capacitif d'un disjoncteur comporte une station d'essais capacitive 1 et une chaine 2 d'acquisition et de traitement de données pour effectuer des mesures avec une haute précision. Pour simplifier la figure, les liaisons entre la station d'essais capacitive 1 et la chaine 2 d'acquisition et de traitement de données n'ont pas été représentées. De même, des capteurs de mesure de tension non représentés équipent la station de test.

La station d'essais capacitive 1 de la station de test est de type synthétique. Cela signifie que l'on n'utilise pas un réseau moyenne ou haute tension ou une station de puissance, mais un dispositif expérimental qui synthétise les caractéristiques de tensions et de courant lors de manœuvre d'ouverture et de fermeture d'un tel réseau.

La station d'essais capacitive 1 comporte les éléments suivantes :

* Un module électrique 11 pour créer le courant d'appel,
* Un module électrique 12 pour créer le courant capacitif,
* Un module électrique 13 pour créer la tension de rétablissement après une coupure capacitive,
* Un module de synchronisation 14.

Les modules électriques 11, 12 et 13 sont reliés à un disjoncteur en test D via des contacteurs ou disjoncteurs moyenne ou haute tension respectifs 15, 16 et 17.

Le module électrique 11 pour créer le courant d'appel comporte une source de tension, un banc capacitif et un banc inductif. Le banc capacitif comporte des capacités assemblées en séries et/ou parallèles pour obtenir une valeur de capacité C requise pour le test. Le banc inductif comporte des inductions assemblées en séries et/ou parallèles pour obtenir une valeur d'induction L requise pour le test. Les capacités sont chargées à la tension crête Vc assignée du réseau : Vc = Va x (2/3)$^{0.5}$, où Va est la tension retenue pour le test, par exemple une tension normalisée.

Les valeurs de capacité C et d'induction L des bancs inductif et capacitif sont déterminées de la manière suivante :

$$C= Ic/Vc \times 1/(2\pi f) \qquad [1]$$

$$L = Vc/Ic \times 1/(2\pi f) \qquad [2]$$

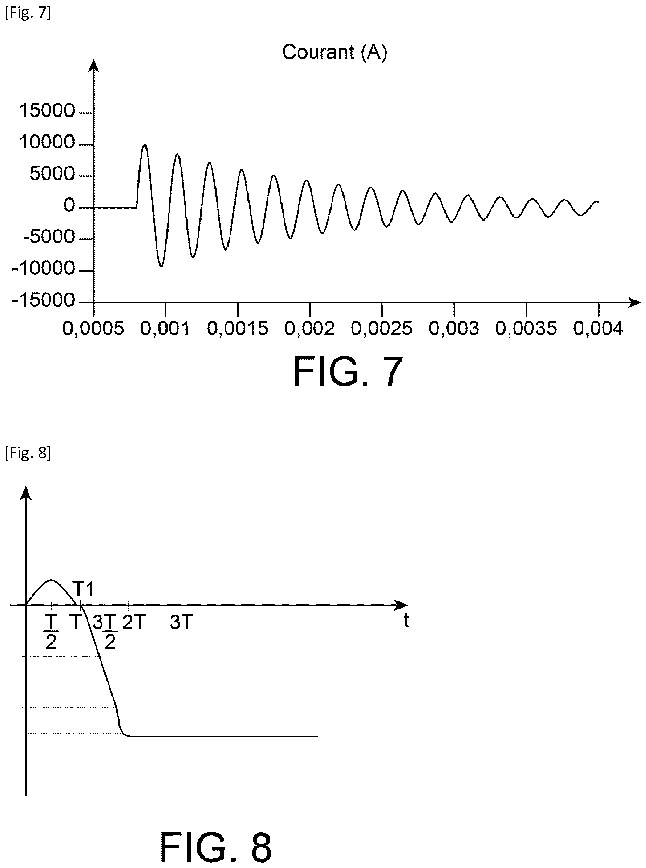

où Ic est le courant d'appel crête, Vc est défini plus haut et f est la fréquence. Suivant différentes variantes, la valeur de courant d'appel peut être celle préconisée par les normes ou une valeur supérieure ou encore inférieure. La fréquence peut être 4250 Hz telle qu'indiquée dans les normes ou une valeur acceptable par les normes. Un exemple de courant d'appel est représenté à la **figure 7.**

Le module électrique 12 pour créer le courant capacitif est réalisé à l'aide d'un circuit basse tension par exemple de quelques centaines de Volts. La fonction de ce module est de créer une onde à 50 ou 60 Hz. Suivant différentes variantes, la valeur de courant capacitif est celle préconisée par les normes, ou une valeur supérieure ou encore inférieure. L'onde est réalisée en chargeant une capacité et en la déchargeant à travers une inductance. Les valeurs de capacité et d'inductance sont déterminées en utilisant des équations similaires aux équations [1 & 2].

Un exemple de courant capacitif est représenté à la **figure 8.** Le courant capacitif est une demi-sinusoïde entre les instants t = 0 et t = T.

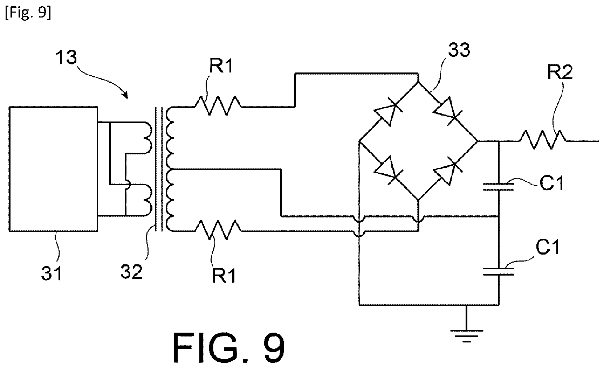

Le module électrique 13 pour créer la tension de rétablissement est représenté à la **figure 9.** Ce module a pour fonction de créer une tension de rétablissement supérieure ou égale à celle d'un test capacitif.

Ce module tient compte d'un point particulier des normes : pendant le premier quart de période (5 ms à 50 Hz, 4,2 ms à 60 Hz), les re-allumages sont acceptables.

Le module électrique 13 pour créer la tension de rétablissement comporte tout d'abord une source 31 de basse tension à amplitude et fréquence réglable.

La figure 8 représente également la tension de rétablissement, qui apparaît à partir d'un instant T1 d'injection de la tension de rétablissement, l'instant étant postérieur à l'instant T précédemment défini. A partir de l'instant T1, la tension de rétablissement présente un front de montée puis se stabilise à une valeur de plateau.

Le réglage de la fréquence permet de régler la vitesse de montée en tension. Ainsi, il est possible d'augmenter la vitesse de montée en tension en augmentant la fréquence. La source 31 permet donc d'obtenir un front rapide de montée en tension, ce front pouvant être plus rapide que celui obtenu lors d'un test capacitif effectué avec une station de puissance. En augmentant la tension, il est possible d'augmenter la valeur de la tension dans la partie en plateau de la courbe de tension de la figure 8.

La sortie de la source 31 de basse tension à amplitude et fréquence réglable est reliée à l'entrée d'un transformateur-élévateur 32 moyenne ou haute tension. Le transformateur-élévateur 32 peut être un transformateur-élévateur à point milieu (dit « de Latour ») qui produit une tension doublée par rapport à la tension qui lui est appliquée.

En variante, il est possible d'utiliser plusieurs transformateurs-élévateurs pour obtenir la puissance voulue.

La sortie du transformateur-élévateur 32 est reliée à des résistances de charge R1, qui servent à la protection en cas de défaut.

Les résistances de charge R1 sont reliées à l'entrée d'un circuit de redressement 33 tel qu'un pont redresseur de Graetz.

La sortie du pont redresseur de Graetz est reliée à une ou des capacité(s) de filtrage C1 et une ou des résistance(s) R2 de limitation du courant.

La capacité de filtrage C1 filtre la tension obtenue et élimine la fréquence de la source de basse tension à amplitude et fréquence réglable. La résistance R2 de limitation du courant limite le courant crête de claquage. Par exemple, la résistance est de 6,25 MOhms.

Le module de synchronisation 14 synchronise les modules électriques 11, 12 et 13. Il est réalisé à l'aide d'un automate programmable ou d'un ordinateur. Ainsi, la tension de rétablissement est appliquée immédiatement après le courant capacitif avec un contrôle inférieur à la centaine de microsecondes. Des contrôles de niveaux de tension de rétablissement sont effectués après le zéro de courant capacitif pour vérifier la validité du test d'ouverture. Un exemple de synchronisation est représenté sur la **figure 8,** sur laquelle l'instant T1 d'injection de la tension de rétablissement est juste postérieur à l'instant T où le courant capacitif s'annule.

En référence à nouveau à la figure 6, la chaine 2 d'acquisition et de traitement de données a la structure générale d'un ordinateur. Elle comporte notamment un processeur 100 exécutant un programme d'ordinateur mettant en œuvre le procédé selon l'invention, une mémoire 101, une interface d'entrée 102 et une interface de sortie 103.

Ces différents éléments sont classiquement reliés par un bus 105.

L'interface d'entrée 102 est reliée aux capteurs de tension et est destinée à recevoir les grandeurs mesurées.

Le processeur 100 exécute les traitements exposés plus haut. Ces traitements sont réalisés sous la forme d'instructions de code du programme d'ordinateur qui sont mémorisées par la mémoire 101 avant d'être exécutées par le processeur 100.

La mémoire 101 mémorise les valeurs mesurées, les valeurs de référence et les diagnostics établis. La mémoire 101 peut être scindée en différentes parties pour séparer les instructions, les valeurs de référence et les valeurs mesurées.

L'interface de sortie 103 est par exemple reliée à une interface homme machine.

**Revendications**

1. Procédé de test de coupure de courant capacitif d'un disjoncteur, comportant des étapes de :

   - Réalisation (E2) d'une coupure de courant capacitif par le disjoncteur,
   - Mesure (E2) de tension aux bornes du disjoncteur après la coupure de courant capacitif, le procédé étant **caractérisé en ce qu'**il comporte des étapes de:

     - Calcul (E3) du gradient de la tension mesurée,
     - Détermination (E4) s'il existe au moins un point de gradient dont l'amplitude présente une valeur absolue supérieure à un premier seuil prédéterminé, et lorsqu'un tel point est déterminé,
     - Identification (E5) de l'instant d'apparition du point déterminé et de l'amplitude de variation de la tension à cet instant, en tant que chute de tension.

2. Procédé de test de coupure de courant capacitif d'un disjoncteur selon la revendication 1, dans lequel la tension est mesurée avec une fréquence d'échantillonnage supérieure à 10 MHz.

3. Procédé de test de coupure de courant capacitif d'un disjoncteur selon la revendication 1 ou 2, dans lequel l'étape (E3) de calcul du gradient de la tension mesurée comporte un filtrage passe-haut de la tension mesurée.

4. Procédé de test de coupure de courant capacitif d'un disjoncteur selon l'une quelconque des revendications 1 à 3, le disjoncteur comportant plusieurs phases, le procédé étant effectué pour chaque phase, le procédé comportant les étapes supplémentaires de :

   - Interpolation (E6) des valeurs de mesure de tension aux bornes du disjoncteur après l'instant de chute de tension, pour obtenir une courbe de tension, pour chaque phase,
   - Calcul (E6) d'un temps de recharge de la courbe de tension obtenue, pour chaque phase,
   - Comparaison (E6) du temps de recharge de la courbe de tension obtenue avec un temps de recharge prédéterminé, pour chaque phase,
   - Identification (E7) d'une phase pour laquelle il y a correspondance entre le temps de recharge calculé et le temps de recharge prédéterminé.

5. Procédé de test de coupure de courant capacitif d'un disjoncteur selon l'une quelconque des revendications 1 à 3, le disjoncteur comportant plusieurs phases, le procédé étant effectué pour chaque phase, le procédé comportant les étapes supplémentaires de :

   - Comparaison (E6) de la valeur absolue de l'amplitude de gradient pour chaque point déterminé pour chaque phase, avec un second seuil prédéterminé,
   - Identification (E7) d'une phase pour laquelle la valeur absolue de l'amplitude de gradient au point déterminé est supérieure au second seuil prédéterminé.

6. Station de test de coupure de courant capacitif d'un disjoncteur, comportant

   - Des modules électriques (11, 12, 13) adaptés pour réaliser une coupure de courant capacitif par le disjoncteur,
   - Une chaîne (2) d'acquisition et de traitement de données adaptée pour mesurer la tension aux bornes du disjoncteur après la coupure de courant capacitif, **caractérisé en ce que** la chaîne d'acquisition est adaptée pour calculer le gradient de la tension mesurée, pour déterminer s'il existe au moins un point de gradient dont l'amplitude présente une valeur absolue supérieure à un premier seuil prédéterminé, et lorsqu'un tel point est déterminé, et pour identifier l'instant d'apparition du point déterminé et l'amplitude de variation de la tension à cet instant, en tant que chute de tension.

**7.** Station de test de coupure de courant capacitif d'un disjoncteur selon la revendication 6, comportant :

- Un module électrique (11) pour créer le courant d'appel,
- Un module électrique (12) pour créer le courant capacitif,
- Un module électrique (13) pour créer la tension de rétablissement après une coupure capacitive,
- Un module de synchronisation (14) pour synchroniser les modules électriques précédents.

**8.** Station de test de coupure de courant capacitif d'un disjoncteur selon la revendication 7, dans laquelle le module électrique (13) pour créer la tension de rétablissement après une coupure capacitive comporte une source (31) de basse tension à amplitude et fréquence réglable, un transformateur-élévateur (32) et un circuit de redressement (33).

**9.** Station de test de coupure selon l'une quelconque des revendications 6 à 8, comprenant un ordinateur pour exécuter un programme d'ordinateur comportant des instructions pour l'exécution des étapes du procédé selon l'une quelconque des revendications 1 à 5.

**10.** Station de test de coupure selon la revendication 9, comprenant un support d'enregistrement sur lequel est enregistré le programme d'ordinateur.

**Patentansprüche**

**1.** Verfahren zum Testen des Abschaltens kapazitiven Stroms eines Schutzschalters, aufweisend folgende Schritte:

- Durchführen (E2) eines Abschaltens kapazitiven Stroms durch den Schutzschalter,
- Messen (E2) von Spannung an den Anschlüssen des Schutzschalters nach dem Abschalten kapazitiven Stroms, wobei das Verfahren **dadurch gekennzeichnet ist, dass** es folgende Schritte aufweist:

- Berechnen (E3) des Gradienten der gemessenen Spannung,
- Bestimmen (E4), ob wenigstens ein Gradientenpunkt vorhanden ist, dessen Amplitude einen Absolutwert aufweist, der größer als eine erste vorbestimmte Schwelle ist, und wenn ein solcher Punkt bestimmt ist,
- Ermitteln (E5) des Zeitpunkts des Auftretens des bestimmten Punkts und der Variationsamplitude der Spannung zu diesem Zeitpunkt als Spannungsabfall.

**2.** Verfahren zum Testen des Abschaltens kapazitiven Stroms eines Schutzschalters nach Anspruch 1, wobei die Spannung mit einer Abtastfrequenz über 10 MHz gemessen wird.

**3.** Verfahren zum Testen des Abschaltens kapazitiven Stroms eines Schutzschalters nach Anspruch 1 oder 2, wobei der Schritt (E3) des Berechnens des Gradienten der gemessenen Spannung ein Hochpassfiltern der gemessenen Spannung umfasst.

**4.** Verfahren zum Testen des Abschaltens kapazitiven Stroms eines Schutzschalters nach einem der Ansprüche 1 bis 3, wobei der Schutzschalter mehrere Phasen aufweist, wobei das Verfahren für jede Phase durchgeführt wird, wobei das Verfahren die folgenden zusätzlichen Schritte aufweist:

- Interpolieren (E6) der Spannungsmesswerte an den Anschlüssen des Schutzschalters nach dem Zeitpunkt des Spannungsabfalls zum Erhalt einer Spannungskurve für jede Phase,
- Berechnen (E6) einer Wiederaufladezeit der erhaltenen Spannungskurve für jede Phase,
- Vergleichen (E6) der Wiederaufladezeit der erhaltenen Spannungskurve mit einer vorbestimmten Wiederaufladezeit für jede Phase,
- Ermitteln (E7) einer Phase, für welche eine Übereinstimmung zwischen der berechneten Wiederaufladezeit und der vorbestimmten Wiederaufladezeit vorliegt.

**5.** Verfahren zum Testen des Abschaltens kapazitiven Stroms eines Schutzschalters nach einem der Ansprüche 1 bis 3, wobei der Schutzschalter mehrere Phasen aufweist, wobei das Verfahren für jede Phase durchgeführt wird, wobei das Verfahren die folgenden zusätzlichen Schritte aufweist:

- Vergleichen (E6) des Absolutwerts der Gradientenamplitude für jeden bestimmten Punkt für jede Phase mit einer zweiten vorbestimmten Schwelle,
- Ermitteln (E7) einer Phase, für welche der Absolutwert der Gradientenamplitude am bestimmten Punkt größer als die zweite vorbestimmte Schwelle ist.

6. Station zum Testen des Abschaltens kapazitiven Stroms eines Schutzschalters, aufweisend:

- Elektrische Module (11, 12, 13), die geeignet sind, eine Abschaltung kapazitiven Stroms durch den Schutzschalter durchzuführen,
- Eine Anlage (2) zur Erfassung und Verarbeitung von Daten, die geeignet ist, die Spannung an den Anschlüssen des Schutzschalters nach dem Abschalten kapazitiven Stroms zu messen, **dadurch gekennzeichnet, dass** die Erfassungsanlage geeignet ist, den Gradienten der gemessenen Spannung zu berechnen, zu bestimmen, ob wenigstens ein Gradientenpunkt vorhanden ist, dessen Amplitude einen Absolutwert aufweist, der größer als eine erste vorbestimmte Schwelle ist, und wenn ein solcher Punkt bestimmt ist, und den Zeitpunkt des Auftretens des bestimmten Punkts und die Variationsamplitude der Spannung zu diesem Zeitpunkt als Spannungsabfall zu ermitteln.

7. Station zum Testen des Abschaltens kapazitiven Stroms eines Schutzschalters nach Anspruch 6, aufweisend:

- Ein elektrisches Modul (11) zur Erzeugung des Einschaltstroms,
- Ein elektrisches Modul (12) zur Erzeugung des kapazitiven Stroms,
- Ein elektrisches Modul (13) zur Erzeugung der Wiederherstellungsspannung nach einer kapazitiven Abschaltung,
- Ein Synchronisierungsmodul (14) zur Synchronisierung der vorgenannten elektrischen Module.

8. Station zum Testen des Abschaltens kapazitiven Stroms eines Schutzschalters nach Anspruch 7, wobei das elektrische Modul (13) zur Erzeugung der Wiederherstellungsspannung nach einer kapazitiven Abschaltung eine Quelle (31) für Niederspannung mit einstellbarer Amplitude und Frequenz, einen Aufwärtstransformator (32) und eine Gleichrichterschaltung (33) aufweist.

9. Abschaltungsteststation nach einem der Ansprüche 6 bis 8, umfassend einen Computer zur Ausführung eines Computerprogramms, das Anweisungen zur Ausführung der Schritte des Verfahrens nach einem der Ansprüche 1 bis 5 aufweist.

10. Abschaltungsteststation nach Anspruch 9, umfassend ein Speichermedium, auf dem das Computerprogramm gespeichert ist.


**Claims**

1. Method for testing capacitive current switching of a circuit breaker, comprising steps of:

- realisation (E2) of a capacitive current switching by the circuit breaker,
- measurement (E2) of voltage at the terminals of the circuit breaker after the capacitive current switching, the method being **characterized in that** it comprises steps of:

- calculation (E3) of the gradient of the measured voltage,
- determination (E4) as to whether there is at least one point of gradient whose amplitude exhibits an absolute value greater than a first predetermined threshold, and when such a point is determined,
- identification (E5) of the instant of appearance of the determined point and of the amplitude of variation of the voltage at that instant, as voltage drop.

2. Method for testing capacitive current switching of a circuit breaker according to Claim 1, wherein the voltage is measured with a sampling frequency greater than 10 MHz.

3. Method for testing capacitive current switching of a circuit breaker according to Claim 1 or 2, wherein the step (E3) of calculation of the gradient of the measured voltage comprises a high-pass filtering of the measured voltage.

4. Method for testing capacitive current switching of a circuit breaker according to any one of Claims 1 to 3, the circuit breaker comprising several phases, the method being performed for each phase, the method comprising the additional steps of:

   - interpolation (E6) of the voltage measurement values at the terminals of the circuit breaker after the instant of voltage drop, to obtain a voltage curve, for each phase,
   - calculation (E6) of a recharge time of the voltage curve obtained, for each phase,
   - comparison (E6) of the recharge time of the voltage curve obtained with a predetermined recharge time, for each phase,
   - identification (E7) of a phase for which there is a match between the calculated recharge time and the predetermined recharge time.

5. Method for testing capacitive current switching of a circuit breaker according to any one of Claims 1 to 3, the circuit breaker comprising several phases, the method being performed for each phase, the method comprising the additional steps of:

   - comparison (E6) of the absolute value of the amplitude of gradient for each point determined for each phase, with a second predetermined threshold,
   - identification (E7) of a phase for which the absolute value of the amplitude of gradient at the determined point is greater than the second predetermined threshold.

6. Station for testing capacitive current switching of a circuit breaker, comprising:

   - electrical modules (11, 12, 13) suitable for carrying out a capacitive current switching by the circuit breaker,
   - a data acquisition and processing chain (2) suitable for measuring the voltage at the terminals of the circuit breaker after the capacitive current switching, **characterized in that** the acquisition chain is adapted to calculate the gradient of the measured voltage, to determine whether there is at least one point of gradient whose amplitude exhibits an absolute value greater than a first predetermined threshold, and when such a point is determined, and to identify the instant of appearance of the determined point and the amplitude of variation of the voltage at that instant, as voltage drop.

7. Station for testing capacitive current switching of a circuit breaker according to Claim 6, comprising:

   - an electrical module (11) for creating the inrush current,
   - an electrical module (12) for creating the capacitive current,
   - an electrical module (13) for creating the recovery voltage after a capacitive switching,
   - a synchronisation module (14) for synchronising the above electrical modules.

8. Station for testing capacitive current switching of a circuit breaker according to Claim 7, wherein the electrical module (13) for creating the recovery voltage after a capacitive switching comprises a source (31) of low voltage with adjustable amplitude and frequency, a step-up transformer (32) and a rectifying circuit (33).

9. Station for testing switching according to any one of Claims 6 to 8, comprising a computer for executing a computer program comprising instructions for the execution of the steps of the method according to any one of Claims 1 to 5.

10. Station for testing switching according to Claim 9, comprising a storage medium on which the computer program is stored.

[Fig. 1]

FIG. 1

[Fig. 2]

FIG. 2

[Fig. 3]

Grad U [V/dt]

FIG. 3

[Fig. 4]

FIG. 4

[Fig. 5]

FIG. 5

[Fig. 6]

FIG. 6

[Fig. 7]

Courant (A)

FIG. 7

[Fig. 8]

FIG. 8

[Fig. 9]

FIG. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 1181322 B

**Littérature non-brevet citée dans la description**

- Discussion on the problem about capacitive current switching of EHV and UHV AC circuit breaker. **SILI YAO et al.** 2017 4TH INTERNATIONAL CONFERENCE ON ELECTRIC POWER EQUIPMENT - SWITCHING TECHNOLOGY (ICEPE-ST). IEEE, 22 Octobre 2017

- Comparing Direct and Synthetic Tests for Interruption of Line-Charging Capacitive Current. **GAETAN DAIGNEAULT et al.** IEEE TRANSACTIONS ON POWER DELIVERY. IEEE SERVICE CENTER, 01 Juillet 2001, vol. 16
- A circuit-breaker restrike diagnostic algorithm using ATP and wavelet transforms. **SHUI-CHEONG KAM et al.** UNIVERSITIES POWER ENGINEERING CONFERENCE (AUPEC), 2011 21ST AUSTRALASIAN. IEEE, 25 Septembre 2011